# EUROPEAN PATENT SPECIFICATION

(11) **EP 4 450 995 B1**
(45) Date of publication and mention of the grant of the patent: **25.03.2026**
(21) Application number: 22926205.0
(22) Date of filing: 08.12.2022
(51) Int. Cl.: G01R 35/00, G01R 31/382, G01R 15/20, G01R 19/00, G01R 19/30, G01R 19/10, G01R 19/165, G08C 19/02, G01R 31/396, G01R 31/371, G01R 15/00, G01R 31/28

(54) **CURRENT SENSOR DIAGNOSIS METHOD, AND CURRENT SENSOR DIAGNOSIS SYSTEM AND BATTERY SYSTEM PROVIDING THE METHOD**
STROMSENSORDIAGNOSEVERFAHREN, UND STROMSENSORDIAGNOSESYSTEM UND BATTERIESYSTEM MIT DIESEM VERFAHREN
PROCÉDÉ DE DIAGNOSTIC DE CAPTEUR DE COURANT, ET SYSTÈME DE DIAGNOSTIC DE CAPTEUR DE COURANT ET SYSTÈME DE BATTERIE FOURNISSANT LEDIT PROCÉDÉ

(30) Priority: 08.02.2022 KR 20220016120
(43) Date of publication of application: 23.10.2024
(73) Proprietor: LG Energy Solution, LTD., Seoul 07335 (KR)
(72) Inventor: PARK, Junsik, Daejeon 34122 (KR)
(74) Representative: Plasseraud IP
(86) International application number: PCT/KR2022/019973
(87) International publication number: WO 2023/153608

(56) References cited:
- KR-A- 20190 069 894
- KR-A- 20190 073 066
- KR-B1- 101 266 346
- KR-B1- 102 037 149
- KR-B1- 102 101 908
- US-A1- 2019 140 566
- US-A1- 2021 231 713

## Description

### [Technical Field]

### CROSS-REFERENCE TO RELATED APPLICATION

This application claims priority to and the benefit of Korean Patent Application No. 10-2022-0016120 filed in the Korean Intellectual Property Office on February 8, 2022.

The present invention relates to a current sensor diagnosis method, and a current sensor diagnosis system and a battery system providing the method.

### [Background Art]

A current sensor is a sensor that senses a DC current or an AC current using a Hall sensor, a sense resistor, or the like. Recently, as the use of secondary battery cells has expanded to mobile devices, such as mobile phones and tablet PCs, as well as electric vehicles (EV, HEV, PHEV) and large-capacity power storage devices (ESS), interest and demand for a technology for accurately diagnosing whether or not an error has occurred in a current sensor that senses a charge/discharging current of a secondary battery cell is rapidly increasing.

Meanwhile, when the current sensor is out of order or inaccurate, there is a problem in that the measured current value is unreliable, and data (for example, voltage value) calculated based on the current value is also unreliable.

In the related art, when two or more current sensors are used in the same current line in a system, a method of diagnosing an error of a current sensor by comparing a difference value between two measured current values with a reference value has been widely used.

However, when a preset (fixed) reference value is used regardless of the size of the current to be measured, there is a problem in that error diagnosis of the current sensor is not accurate. For example, when the reference value is calculated based on a large amount of current or when the size of the current to be measured is small, a problem of erroneously diagnosing the state of the current sensor that is out of the actual reference range as a normal state may occur. Conversely, when the reference value is calculated based on a small amount of current or when the size of the measured current is large, a problem of erroneously diagnosing the state of the current sensor that is within the actual reference range as a defective state may occur.

US2021231713A1 discloses a current sensor diagnosing apparatus and method.

### [Disclosure]

### [Technical Problem]

The present invention provides a current sensor diagnosis method of precisely diagnosing an error of a current sensor by using a reference value corresponding to the size of current measured by a current sensor, rather than a fixed reference value, and a current sensor diagnosis system and a battery system providing the method.

### [Technical Solution]

A current sensor diagnosis system according to one characteristic of the present invention includes: a first current sensor; a second current sensor connected in series with the first current sensor; a communication unit configured to receive a first current value measured by the first current sensor and a second current value measured by the second current sensor; and a control unit configured to select a current section to which the first current value and the second current value belong among a plurality of current sections distinguished by a size of a current, calculate a difference value between the first current value and the second current value, compare the difference value with a section reference value corresponding to the selected current section, and diagnose a state of the first current sensor and the second current sensor.

The section reference value may be determined by multiplying a predetermined current value among a plurality of current values belonging to the current section by a predetermined error ratio.

The section reference value may be determined by multiplying a maximum current value of the current section by a predetermined error ratio.

The current sensor diagnosing system may further include a storage unit for storing a minimum current value, a maximum current value, and a section reference value of each of the plurality of current sections.

When the difference value is equal to or greater than the section reference value, the control unit may diagnose at least one of the first current sensor and the second current sensor as an error state.

A battery system according to another exemplary embodiment of the present invention includes: a battery including a plurality of battery cells; a first current sensor connected in series to a current path between the battery and an external device to measure a charging current or a discharging current of the battery; a second current sensor connected in series with the first current sensor to measure the charging current or the discharging current; and a Battery Management System (BMS) configured to receiving a first current value measured by the first current sensor and a second current value measured by the second current sensor, select a current section to which the first current value and the second current value belong among a plurality of current sections distinguished by a size of a current, calculate a difference value between the first current value and the second current value, compare the difference value with a section reference value corresponding to the selected current section, and diagnose a state of the first current sensor and the second current sensor.

The section reference value may be determined by multiplying a predetermined current value among a plurality of current values belonging to the current section by a predetermined error ratio.

The section reference value may be determined by multiplying a maximum current value of the current section by a predetermined error ratio.

When the difference value is equal to or greater than the section reference value, the BMS may diagnose at least one of the first current sensor and the second current sensor as an error state.

A current sensor diagnosing method according to still another exemplary embodiment of the present invention includes: receiving a first current value measured by a first current sensor and a second current value measured by a second current sensor connected in series with the first current sensor; selecting a current section to which the first current value and the second current value belong among a plurality of current sections distinguished by a size of a current, and determining a section reference value corresponding to the selected current section; comparing a difference value between the first current value and the second current value with the section reference value; and diagnosing a state of the first current sensor and the second current sensor based on a result of the comparison.

The determining of the section reference value may include determining the section reference value by multiplying a predetermined current value among a plurality of current values belonging to the current section by a predetermined error ratio.

The determining of the section reference value may include determining the section reference value by multiplying a maximum current value of the current section by a predetermined error ratio.

The diagnosing of the state includes, when the difference value is equal to greater than the section reference value, diagnosing at least one of the first current sensor and the second current sensor as an error state.

### [Advantageous Effects]

According to the present invention, it is possible to reduce the possibility of misdiagnosis of the current sensor by using a reference value corresponding to the size of the current measured by the current sensor, instead of a fixed reference value.

The present invention diagnoses an error of the current sensor by using only the current values of the two current sensors, It is possible to diagnose the error of the current sensor in the same way regardless of the type of system using the current sensor, the type of current source, or voltage characteristics, and the present invention is easily applicable to various systems including a plurality of current sensors.

The present invention compares the current values measured by the two current sensors at the same time to determine whether an error in the current sensor has occurred, so that it is possible to accurately diagnose an error case when a measurement error occurs in the current value due to a decrease in response speed or phase delay of the current sensor, as well as an error state when the current sensor does not work at all.

### [Description of the Drawings]

FIG. 1 is a block diagram illustrating a current sensor diagnosis system providing a current sensor diagnosis method according to an exemplary embodiment.
FIG. 2 is an exemplary diagram for describing a method of setting a reference value according to an exemplary embodiment.
FIG. 3 is a diagram for describing a fixed reference value.
FIG. 4 is a diagram for describing the accuracy of error diagnosis when a fixed reference value is applied.
FIG. 5 is a diagram for describing a section reference value according to an exemplary embodiment.
FIG. 6 is a diagram for describing the accuracy of error diagnosis when a section reference value is applied.
FIG. 7 is a block diagram illustrating a battery system providing the current sensor diagnosis method according to another exemplary embodiment.
FIG. 8 is a flowchart illustrating a current sensor diagnosis method according to another exemplary embodiment.

### [Mode for Invention]

Hereinafter, an exemplary embodiment disclosed the present specification will be described in detail with reference to the accompanying drawings, and the same or similar constituent element is denoted by the same reference numeral regardless of a reference numeral, and a repeated description thereof will be omitted. Suffixes, "module" and and/or "unit" for a constituent element used for the description below are given or mixed in consideration of only easiness of the writing of the specification, and the suffix itself does not have a discriminated meaning or role. Further, in describing the exemplary embodiment disclosed in the present disclosure, when it is determined that detailed description relating to well-known functions or configurations may make the subject matter of the exemplary embodiment disclosed in the present disclosure unnecessarily ambiguous, the detailed description will be omitted. Further, the accompanying drawings are provided for helping to easily understand exemplary embodiments disclosed in the present specification, and the present specification is not limited by the accompanying drawings, and it will be appreciated that the present invention includes all of the modifications, and substitutes included in the technical scope of the present invention according to the appended claims.

Terms including an ordinary number, such as first and second, are used for describing various constituent elements, but the constituent elements are not limited by the terms. The terms are used only to discriminate one constituent element from another constituent element.

It should be understood that when one constituent element is referred to as being "coupled to" or "connected to" another constituent element, one constituent element can be directly coupled to or connected to the other constituent element, but intervening elements may also be present. By contrast, when one constituent element is referred to as being "directly coupled to" or "directly connected to" another constituent element, it should be understood that there are no intervening elements.

In the present application, it will be appreciated that terms "including" and "having" are intended to designate the existence of characteristics, numbers, operations, operations, constituent elements, and components described in the specification or a combination thereof, and do not exclude a possibility of the existence or addition of one or more other characteristics, numbers, operations, operations, constituent elements, and components, or a combination thereof in advance.

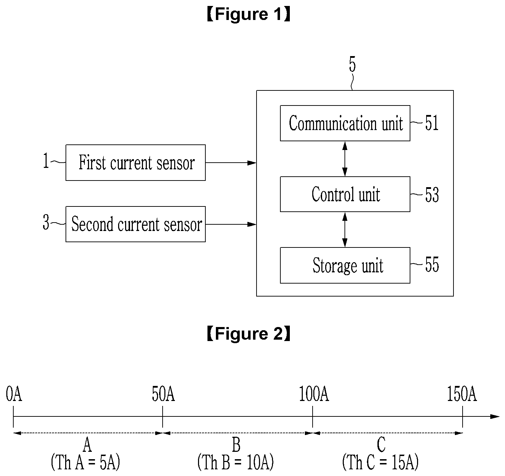

FIG. 1 is a block diagram illustrating a current sensor diagnosis system providing a current sensor diagnosis method according to an exemplary embodiment, and FIG. 2 is an exemplary diagram for describing a method of setting a reference value according to an exemplary embodiment.

Referring to FIG. 1, a current sensor diagnosis system includes a first current sensor 1, a second current sensor 3, and a diagnosis device 5.

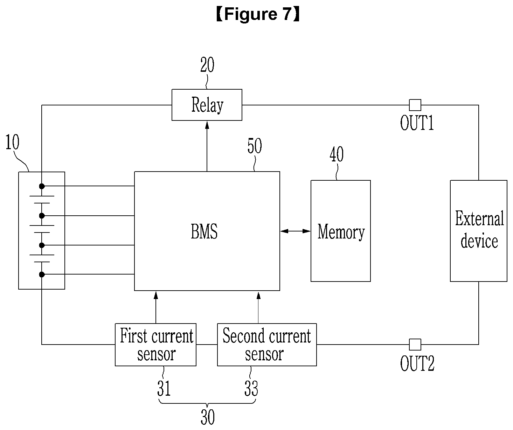

The current sensor diagnosis system may diagnose an error occurring in at least one current sensor among the plurality of current sensors 1 and 3 configured to measure the same current. In FIG. 1 and FIG. 7 below, two current sensors 1 and 3 are illustrated, but the present invention is not limited thereto. That is, the current sensor diagnosis system may include two or more current sensors that sense the same current, and may diagnose an error of the current sensor based on a first current value and a second current value sensed by the specific two current sensors.

The first current sensor 1 and the second current sensor 3 are configured to measure the same current. For example, a series circuit in which the first current sensor 1 and the second current sensor 3 are connected in series may be configured to be connected in series on a current path through which current flows. For another example, when the first current sensor 1 and the second current sensor 3 are designed to have the same equivalent resistance, a parallel circuit in which the first current sensor 1 and the second current sensor 3 are connected in parallel to each other may be configured to be connected in series on a line through which current flows.

Depending on the exemplary embodiment, in the battery system as illustrated in FIG. 7 below, the first current sensor 1 and the second current sensor 3 may be connected in series to a current line through which a charging current or a discharging current of the battery 10 flows.

The first current sensor 1 and the second current sensor 3 may measure the same current at the same timing and transmit the measured current value to the diagnosis device 5. For example, the first current sensor 1 and the second current sensor 3 may measure the same current at the same timing in real time or at predetermined intervals, and transmit the measurement result to the diagnosis device 5.

The first current sensor 1 and the second current sensor 3 may be formed of hall sensors or sense resistors. The diagnostic device 5 may receive a voltage signal output from the hall sensor or a voltage applied between both terminals of the sense resistor, and determine the size of the current using the voltage signal or the measured voltage. The diagnostic device 5 may include an analog-to-digital converter (ADC) to convert the voltage signal output from the hall sensor or the voltage applied to both terminals of the sense resistor into a digital value.

The first current sensor 1 and the second current sensor 3 may not be configured as the same type of sensor. For example, the first current sensor 1 may be configured as a hall sensor, and the second current sensor 3 may be configured as a sense resistor. For another example, the first current sensor 1 may be configured as a sense resistor, and the second current sensor 3 may be configured as a hall sensor. In addition, each of the first current sensor 1 and the second current sensor 3 is not limited to the above example, and may be formed of various current sensors.

The diagnosis device 5 may include a communication unit 51, a control unit 53, and a storage unit 55.

The communication unit 51 may receive the current measurement results transmitted by the first current sensor 1, and the second current sensor 3, and transmit the received current measurement results to the control unit 53.

The control unit 53 may determine a difference value between the first current value and the second current value, and compare the difference value with a section reference value to diagnose an error of at least one of the first current sensor 1 and the second current sensor 3.

First, the control unit 53 may determine the first current value measured by the first current sensor 1 and the second current value measured by the second current sensor 3. For example, when at least one of the first current sensor 1 and the second current sensor 3 is formed of a hall sensor, the control unit 53 estimates a current value based on a voltage signal transmitted by the hall sensor. For another example, when at least one of the first current sensor 1 and the second current sensor 3 is formed of a sense resistor, the control unit 53 estimate the current value based on the voltage value applied between both terminals of the sense resistor. By the existing known method, the control unit 53 may determine the first current value of the first current sensor 1 and the second current value of the second current sensor 3.

Next, the control unit 53 selects a current section to which the first current value and the second current value belong among a plurality of current sections distinguished by the size of the current.

The plurality of current sections may be distinguished by the size of a predetermined current. For example, a plurality of current sections may be distinguished for each 50A size. Referring to FIG. 2, a first current section A may correspond to an interval of a current size of more than 0A to 50A or less, a second current section B may correspond to an interval of a current size of more than 50A to 100A or less, and a third current section C may correspond to an interval of a current size of more than 100A to 150A or less. In FIG. 2, only the first current section A to the third current section C are illustrated, but the present invention is not limited thereto. In addition to the section illustrated in FIG. 2, a fourth section D (more than 150A to 200A or less), a fifth section D (more than 200A to 250A or less), and the like may be further included.

Next, the control unit 53 determines a section reference value corresponding to the selected current section. According to the exemplary embodiment, the section reference value for diagnosing errors of the first current sensor 1 and the second current sensor 3 is not a fixed value, and may be determined by the current size of the selected current section.

According to the exemplary embodiment, the section reference value may be determined by multiplying the maximum current value of each current section by a predetermined error ratio. Referring to FIG. 2, for example, it is assumed that a predetermined error ratio is 10%. Since the minimum current value is 0A and the maximum current value is 50A in the first current section A, the control unit 53 may determine a section reference value TH_A corresponding to the first current section A as 5A (50A × 0.1 = 5A). In the same way, the control unit 53 may determine the section reference value TH_B of the second current section B as 10A (100A × 0.1 = 10A) and determine a section reference value TH_C of the third current section C as 15A (150A × 0.1 = 15A).

According to another exemplary embodiment, the section reference value may be determined by multiplying a minimum current value of each current section by a predetermined error ratio. According to another exemplary embodiment, the section reference value may be determined by multiplying a center current value of each current section by a predetermined error ratio.

In summary, the section reference value may be determined by multiplying a predetermined current value included in a predetermined current section by a predetermined error ratio in each of the plurality of current sections. The predetermined error ratio reflects measurement errors, such as the current sensor itself or a structural problem in the circuit, and may be determined by experiments or the like. For example, the predetermined error ratio may be determined as a rate belonging to 10% or more and 15% or less, but is not limited thereto.

The control unit 53 may calculate a section reference value whenever an error of the current sensor is diagnosed. Alternatively, a plurality of section reference values corresponding to a plurality of current sections is pre-calculated and stored in the storage unit 55, and the control unit 53 may extract the section reference values from the storage unit 55 whenever an error of the current sensor is diagnosed.

Next, the control unit 53 may compare the difference value between the first current value and the second current value with the section reference value, and diagnose an error state of at least one of the first current sensor 1 and the second current sensor 3.

For example, when the difference value is equal to or greater than the reference value, the control unit 53 may diagnose at least one of the first current sensor 1 and the second current sensor 3 as an error state. Also, when the difference value is less than the reference value, the control unit 53 may diagnose both the first current sensor 1 and the second current sensor 3 as a normal state.

The storage unit 55 may store a minimum current value, a maximum current value, and a corresponding section reference value for each of the plurality of current sections. In addition, the storage unit 55 may store current measurement result values of the first current sensor 1 and the second current sensor 3 received through the communication unit 51.

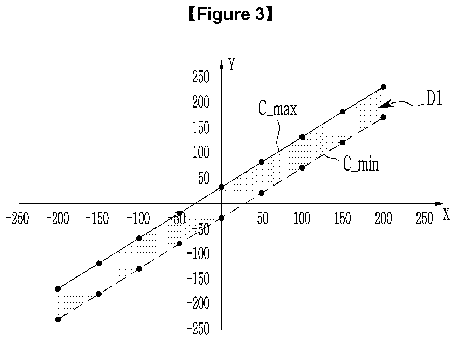

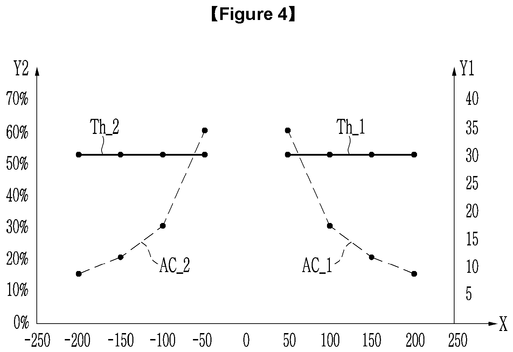

FIG. 3 is a diagram for describing a fixed reference value, and FIG. 4 is a diagram for describing the accuracy of error diagnosis when a fixed reference value is applied.

Referring to FIG. 3, the X-axis may be a first current value measured by the first current sensor 1, and the Y-axis may be a second current value measured by the second current sensor 3. Referring to FIGS. 3 and 7, in the battery system, the charging current may be measured as a positive (+) value and the discharging current may be measured as a negative (-) value.

In FIG. 3, it is assumed that the maximum current value Max Current measurable by the first current sensor 1 and the second current sensor 3 is 200A, the minimum current value Min Current is -200A, and the predetermined error ratio is 15%. For example, the fixed reference value may be determined by multiplying the maximum current value Max Current (200A) by the error ratio (15%). That is, the fixed reference value is 30A (200A × 0.15 = 30A). In this case, according to the method described below, the fixed reference value is constant regardless of the size of the current measured by the first current sensor 1 and the second current sensor 3.

In a predetermined current value, the normal range may be determined as a current value between a lower limit value calculated by subtracting the fixed reference value from a predetermined current value and an upper limit value calculated by adding the fixed reference value to the predetermined current value.

In the entire current section, an upper limit C_max of FIG. 3 may be determined by calculating a plurality of upper limit values corresponding to a plurality of current values and connecting the calculated plurality of upper limit values. In addition, the lower limit C_min of FIG. 3 may be determined by calculating a plurality of lower limit values corresponding to a plurality of current values and connecting the calculated plurality of lower limit values.

Specifically, referring to FIG. 3, the plurality of upper limit values may be determined by a calculation (-170A, -120A, -70A, -20A, 30A, 80A, 130A, 180A, and 230A) of equally adding the fixed reference value (30A) to each of the current values (for example, -200A, -150A, -100A, -50A, 0A, 50A, 100A, 150A, and 200A). In this case, the upper limit C_max may be determined by connecting the plurality of upper limit values I_max (-170A, -120A, -70A, -20A, 30A, 80A, 130A, 180A, and 230A).

Specifically, referring to FIG. 3, the plurality of lower limit values may be determined by a calculation (-230A, -180A, -130A, -80A, -30A, 20A, 70A, 120A, 170A) of equally subtracting the fixed reference value (30A) from each of the current values (for example, -200A, -150A, -100A, -50A, 0A, 50A, 100A, 150A, and 200A). In this case, the lower limit C_min may be determined by connecting the plurality of lower limit values I_min (-230A, -180A, -130A, -80A, - 30A, 20A, 70A, 120A, and 170A).

In FIG. 3, a region D1 between the upper limit C_max and the lower limit C_min may be a normal range. An external region out of the normal range D1 may be an error range. From a theoretical point of view, since the first current sensor 1 and the second current sensor 3 measure the same current, the first current sensor 1 and the second current sensor 3 may be diagnosed as the normal state when the points representing the first current value and the second current value lies on a straight line with a slope of 1. However, in consideration of the allowable error of the current sensors, when the points corresponding to the first current value and the second current value belong to the normal state region D, the corresponding current sensors 1 and 3 may be determined to be in the normal state.

In the case of diagnosing the current sensor 1 and the second current sensor 3 in the same manner as in FIG. 3, many misdiagnosis may occur in a low current section. This is because the fixed reference value (30A) is calculated by multiplying the maximum current value Max Current (200A) by the predetermined error ratio (15%), and the calculated fixed reference value (30A) is equally applied in all current sections. For example, in a section where the size of the current is small (for example, more than 0A to 50A or less), the difference value between the first current value and the second current value may be significantly lower than the fixed reference value 30A. Then, the control unit 53 may erroneously diagnose the current sensor 1 and the second current sensor 3 as the normal state even though the current sensor 1 and the second current sensor 3 are actually in an error state.

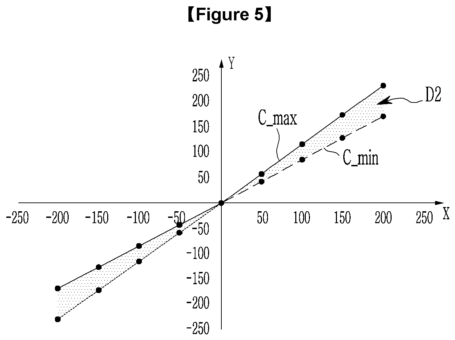

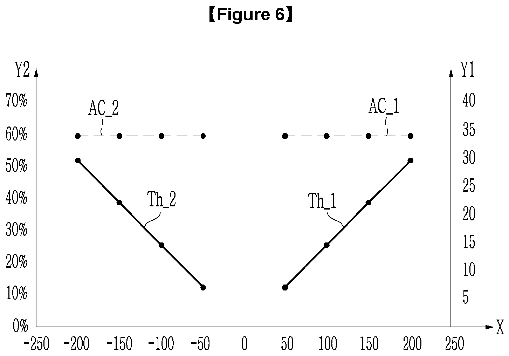

Referring to FIG. 4, the X-axis represents the first current value and the second current value, the Y1-axis represents the fixed reference value, and the Y2-axis represents the accuracy of error diagnosis expressed as a percentile (%). When the current sensor is diagnosed by using the fixed reference values (Th_1, Th_2) in both positive and negative current value regions, it was experimentally confirmed that the accuracy of error diagnosis fluctuates remarkably. In the case of the current sensor diagnosis method (and the current sensor diagnosis system and the battery system providing the method) according to the exemplary embodiment, the above problem may be solved, and a more detailed description will be described below with reference to FIGS. 5 and 6.

FIG. 5 is a diagram for describing a section reference value according to an exemplary embodiment, and FIG. 6 is a diagram for describing the accuracy of error diagnosis when a section reference value is applied.

Referring to FIG. 5, the X axis may be a first current value measured by the first current sensor 1, and the Y axis may be a second current value measured by the second current sensor 3. Referring to FIGS. 5 and 7, in the battery system, the charging current may be measured as a positive (+) value and the discharging current may be measured as a negative (-) value.

In FIG. 5, it is assumed that the maximum current value Max Current measurable by the first current sensor 1 and the second current sensor 3 is 200A, the minimum current value Min Current is -200A, the predetermined error ratio is 15%, and a plurality of current sections may be distinguished at intervals of 50A. According to the exemplary embodiment, the section reference value may be determined by multiplying the maximum current value of each section by an error ratio. In this case, according to a method described below, the section reference value may be different for each current section.

The normal range corresponding to the predetermined current value may be determined as a current value between a lower limit value calculated by subtracting the section reference value from the current value and an upper limit value calculated by adding the section reference value to the current value.

In each of the plurality of current sections, when an upper limit value corresponding to a predetermined current value is calculated and a plurality of upper limit values corresponding to each of the entire current sections (hereinafter, first to fourth current sections) is connected, an upper limit line C_max indicated by a solid line in FIG. 5 may be determined. Further, in each of the plurality of current sections, when a lower limit value corresponding to a predetermined current value is calculated and a plurality of lower limit values corresponding to each of the entire current sections (hereinafter, first to fourth current sections) is connected, a lower limit line C_min indicated by a dotted line in FIG. 5 may be determined.

Specifically, in the first current section (more than 0A to 50A or less) of FIG. 5, the section reference value is 7.5A (50A × 0.15 = 7.5A). For example, the upper limit value corresponding to 50A, which is the maximum current value I_max of the first current section (more than 0A to 50A or less), is 57.5A (50A + 7.5A = 47.5A), and the lower limit value is 42.5A (50A -7.5A = 42.5 A).

Further, in the second current section (more than 50A to 100A or less) of FIG. 5, the section reference value is 15A (100A × 0.15 = 15A). For example, the upper limit value corresponding to 100A, which is the maximum current value I_max of the second current section (more than 50A to 100A or less), is 115A (100A + 15A = 115A), and the lower limit value is 85A (100A - 15A = 85A).

Further, in the third current section (more than 100A to 150A or less) of FIG. 5, the section reference value is 22.5A (150A × 0.15 = 22.5A). For example, the upper limit value corresponding to 150A, which is the maximum current value I_max of the third current section (more than 100A to 150A or less), is 172.5A (150A + 22.5A = 172.5A), and the lower limit value is 127.5A (150A - 22.5A = 127.5A).

Further, in the fourth current section (more than 150A to 200A or less) of FIG. 5, the section reference value is 30A (200A × 0.15 = 30A). For example, the upper limit value corresponding to 200A, which is the maximum current value I_max of the fourth current section (more than 150A to 200A or less), is 230A (200A + 30A = 230A), and the lower limit value is 170A (200A - 30A = 170A). In the same way as above, the upper limit value and the lower limit value may be calculated in each of the plurality of positive current sections (first to fourth current sections) and the plurality of negative current sections having the same absolute value.

Referring to FIG. 5, the upper limit C_max may be determined by connecting the plurality of upper limit values (-170A, -127.5A, -85A, -42.5A, 0, 57.5A, 115A, 172.5A, 230A) described above. The lower limit C_min may be determined by connecting the plurality of lower limit values (-230A, -172.5A, - 115A, -57.5A, 0, 42.5A, 85A, 127.5A, 170A) described above. In this case, the region D2 between the upper limit C_max and the lower limit C_min may be a normal range. An external region out of the normal range D1 may be an error range. In the case of FIG. 5, it can be seen that the smaller the size (absolute value) of the measured current is, the smaller the section reference value is, and the larger the size (absolute value) of the measured current is, the larger the section reference value is.

Referring to FIG. 6, the X-axis represents the first current value and the second current value, the Y1-axis represents the fixed reference value, and the Y2-axis represents the accuracy of error diagnosis expressed as a percentile (%). When the current sensor is diagnosed by using the section reference values (Th_1, Th_2) in both regions in which the current values are the positive value and the negative value, it was experimentally confirmed that the accuracy of error diagnosis was maintained constant. That is, compared to the case of FIG. 4, it can be seen that accuracy is remarkably improved in diagnosing an error of the current sensor by using the section reference value, compared to the case of using the fixed reference value.

FIG. 7 is a block diagram illustrating a battery system providing the current sensor diagnosis method according to another exemplary embodiment.

The battery system of FIG. 7 is an example of a system providing the current sensor diagnosis method, and the present invention is not limited thereto, and the current sensor diagnosis system of FIG. 1 may be included in various systems that require error diagnosis of a current sensor.

In FIG. 7, the battery system includes a battery 10, a relay 20, a current sensor 30, a memory 40, and a battery management system (BMS) 50.

The battery 10 may include a plurality of battery cells (Cell1 to Celln) electrically connected in series and parallel. Each of the plurality of battery cells (Cell1 to Celln) is electrically connected to the BMS 50 through wires. The BMS 50 may collect and analyze various information about battery cells including information about the plurality of battery cells Cell1 to Celln to control charging and discharging of the battery cells, protection operation, and the like, and control an operation of the relay 20.

In Figure 7, the battery 10 is connected between two output terminals OUT1, OUT2 of the battery system, the relay 20 is connected between the positive electrode of the battery system and the first output terminal OUT1, and the current sensor 30 is connected between the negative electrode of the battery system and the second output terminal OUT2. The configurations illustrated in FIG. 7 and the connection relationship between the configurations are examples, but the invention is not limited thereto.

The relay 20 controls electrical connection between the battery system and an external device. When the relay 20 is turned on, the battery system and the external device are electrically connected to charge or discharge, and when the relay 20 is turned off, the battery system and the external device are electrically separated. In this case, the external device may be a charger in a charging cycle in which power is supplied to the battery 10 for charging, and may be a load in a discharging cycle in which the battery 10 discharges power to the external device.

The current sensor 30 is connected in series to a current path between the battery 10 and an external device. The current sensor 30 may measure the battery current, that is, the charging current and the discharging current, flowing through the battery 10 and transmit the measurement result to the BMS 50.

According to the exemplary embodiment, the current sensor 30 may include a plurality of current sensors connected in series. For example, the current sensor 30 may include at least two current sensors connected in series, that is, a first current sensor 31 and a second current sensor 33. The first current sensor 31 and the second current sensor 33 are the same as the first current sensor 1 and the second current sensor 3 described above in FIG. 1, and the description thereof is replaced with the description of FIG. 1.

The BMS 50 may determine a difference value between the first current value and the second current value, and compare the difference value with the section reference value to diagnose an error of at least one of the first current sensor 31 and the second current sensor 33.

First, the BMS 50 may determine the first current value measured by the first current sensor 31 and the second current value measured by the second current sensor 33. For example, when at least one of the first current sensor 31 and the second current sensor 33 is formed of a hall sensor, the BMS 50 estimates a current value based on a voltage signal transmitted by the hall sensor. For another example, when at least one of the first current sensor 31 and the second current sensor 33 is formed of a sense resistor, the BMS 50 estimates a current value based on the voltage value applied between both terminals of the sense resistor. By the existing known method, the BMS 50 may determine the first current value of the first current sensor 31 and the second current value of the second current sensor 33.

Next, the BMS 50 selects a current section to which the first current value and the second current value belong among a plurality of current sections distinguished by the size of the current.

The plurality of current sections may be distinguished by the size of a predetermined current. For example, a plurality of current sections may be distinguished for each 50A size. Referring to FIG. 2, a first current section A may correspond to an interval of a current size of more than 0A to 50A or less, a second current section B may correspond to an interval of a current size of more than 50A to 100A or less, and a third current section C may correspond to an interval of a current size of more than 100A to 150A or less. In FIG. 2, only the first current section A to the third current section C are illustrated, but the present invention is not limited thereto. In addition to the section illustrated in FIG. 2, a fourth section D (more than 150A to 200A or less), a fifth section D (more than 200A to 250A or less), and the like may be further included.

Next, the BMS 50 determines a section reference value corresponding to the selected current section. According to the exemplary embodiment, the section reference value for diagnosing errors of the first current sensor 31 and the second current sensor 33 is not a fixed value, and may be determined by the current size of the selected current section.

According to the exemplary embodiment, the section reference value may be determined by multiplying the maximum current value of each current section by a predetermined error ratio. Referring to FIG. 2, for example, it is assumed that a predetermined error ratio is 10%. Since the minimum current value is 0A and the maximum current value is 50A in the first current section A, the BMS 50 may determine a section reference value TH_A corresponding to the first current section A as 5A (50A × 0.1 = 5A). By the same way, the BMS 50 may determine the section reference value TH_B of the second current section B as 10A (100A × 0.1 = 10A) and determine a section reference value TH_C of the third current section C as 15A (150A × 0.1 = 15A).

According to another exemplary embodiment, the section reference value may be determined by multiplying a minimum current value of each current section by a predetermined error ratio. According to another exemplary embodiment, the section reference value may be determined by multiplying a center current value of each current section by a predetermined error ratio.

In summary, the section reference value may be determined by multiplying a predetermined current value included in a predetermined current section by a predetermined error ratio in each of the plurality of current sections. The predetermined error ratio reflects measurement errors, such as the current sensor itself or a structural problem in the circuit, and may be determined by experiments or the like. For example, the predetermined error ratio may be determined as a rate belonging to 10% or more and 15% or less, but is not limited thereto.

The BMS 50 may calculate a section reference value whenever an error of the current sensor is diagnosed

Alternatively, a plurality of section reference values corresponding to a plurality of current sections is pre-calculated and stored in the memory 40, and the BMS 50 may extract the section reference values from the memory 40 whenever an error of the current sensor is diagnosed.

Next, the BMS 50 may compare the difference value between the first current value and the second current value with the section reference value, and diagnose an error state of at least one of the first current sensor 31 and the second current sensor 33.

For example, when the difference value is equal to or greater than the reference value, the BMS 50 may diagnose at least one of the first current sensor 31 and the second current sensor 33 as an error state

Also, when the difference value is less than the reference value, the BMS 50 may diagnose both the first current sensor 31 and the second current sensor 33 as a normal state.

The memory 40 may store a minimum current value, a maximum current value, and a corresponding section reference value for each of the plurality of current sections. In addition, the memory 40 may store current measurement result values of the first current sensor 31 and the second current sensor 33.

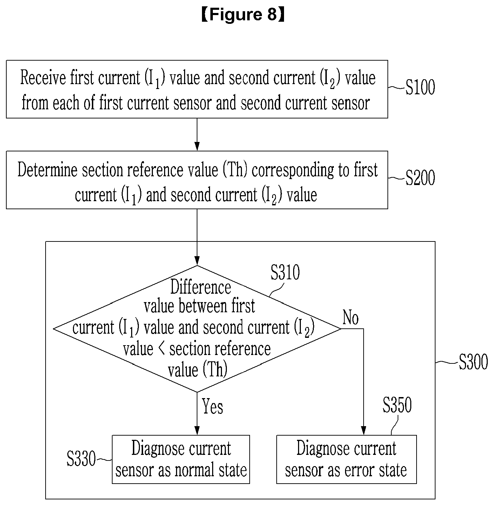

FIG. 8 is a flowchart illustrating a current sensor diagnosis method according to another exemplary embodiment.

Hereinafter, a current sensor diagnosis method, and a current sensor diagnosis system and a battery system providing the method will be described with reference to FIGS. 1 to 8.

Hereinafter, the subject performing the current sensor diagnosis is described as the BMS 50, but is the same as the control unit 53 of the current sensor diagnosis device 5 performing the current sensor diagnosis. Hereinafter, differences between the current sensor diagnosis system and the battery system will be separately described.

First, the BMS 50 receives a first current value measured by the first current sensor 31 and a second current value measured by the second current sensor 33 (S100).

For example, when at least one of the first current sensor 31 and the second current sensor 33 is formed of a hall sensor, the BMS 50 estimates a current value based on a voltage signal transmitted by the hall sensor. For another example, when at least one of the first current sensor 31 and the second current sensor 33 is formed of a sense resistor, the BMS 50 estimates a current value based on the voltage value applied between both terminals of the sense resistor. By the existing known method, the BMS 50 may determine the first current value of the first current sensor 31 and the second current value of the second current sensor 33.

Next, the BMS 50 determines section reference values corresponding to the first current value and the second current value (S200).

In operation S200, the BMS 50 may select a current section to which the first current value and the second current value belong among a plurality of current sections distinguished by the size of the current.

The plurality of current sections may be distinguished by the size of a predetermined current. For example, a plurality of current sections may be distinguished for each 50A size. Referring to FIG. 2, a first current section A may correspond to an interval of a current size of more than 0A to 50A or less, a second current section B may correspond to an interval of a current size of more than 50A to 100A or less, and a third current section C may correspond to an interval of a current size of more than 100A to 150A or less. In FIG. 2, only the first current section A to the third current section C are illustrated, but the present invention is not limited thereto. In addition to the section illustrated in FIG. 2, a fourth section D (more than 150A to 200A or less), a fifth section D (more than 200A to 250A or less), and the like may be further included.

In operation S200, the BMS 50 may determine a section reference value corresponding to the selected current section.

According to the exemplary embodiment, the section reference value for diagnosing errors of the first current sensor 31 and the second current sensor 33 is not a fixed value, and may be determined by the current size of the selected current section.

For example, the section reference value may be determined by multiplying the maximum current value of each current section by a predetermined error ratio. Referring to FIG. 2, for example, it is assumed that a predetermined error ratio is 10%. Since the minimum current value is 0A and the maximum current value is 50A in the first current section A, the BMS 50 may determine a section reference value TH_A corresponding to the first current section A as 5A (50A × 0.1 = 5A). By the same method, the BMS 50 may determine the section reference value TH_B of the second current section B as 10A (100A × 0.1 = 10A) and determine a section reference value TH_C of the third current section C as 15A (150A × 0.1 = 15A).

For another example, the section reference value may be determined by multiplying a minimum current value of each current section by a predetermined error ratio. For another example, the section reference value may be determined by multiplying a center current value of each current section by a predetermined error ratio.

In summary, the section reference value may be determined by multiplying a predetermined current value included in a predetermined current section by a predetermined error ratio in each of the plurality of current sections. The predetermined error ratio reflects measurement errors, such as the current sensor itself or a structural problem in the circuit, and may be determined by experiments or the like. For example, the predetermined error ratio may be determined as a rate belonging to 10% or more and 15% or less, but is not limited thereto.

The BMS 50 may calculate a section reference value whenever an error of the current sensor is diagnosed. Alternatively, a plurality of section reference values corresponding to a plurality of current sections is pre-calculated and stored in the memory 40, and the BMS 50 may extract the section reference values from the memory 40 whenever an error of the current sensor is diagnosed.

Next, the BMS 50 may compare the difference value between the first current value and the second current value with the section reference value, and diagnose an error state of at least one of the first current sensor 31 and the second current sensor 33 according to the comparison result (S300).

In operation S300, the BMS 50 calculates a difference value between the first current value and the second current value, and compares the difference value with the section reference value (S310).

In operation S300, when the difference value as the result of the comparison is less than the section reference value (S310, YES), the BMS 50 diagnoses both the first current sensor 31 and the second current sensor 33 as a normal state (S330).

In operation S300, when the difference value as the result of the comparison is equal to or greater than the section reference value (S310, NO), the BMS 50 diagnoses at least one of the first current sensor 31 and the second current sensor 33 as an error state. (S350).

While this invention has been described in connection with what is presently considered to be practical exemplary embodiments, it is to be understood that the invention is not limited to the disclosed exemplary embodiments.

## Claims

1. A current sensor diagnosing system, comprising:
a first current sensor (1);
a second current sensor (3) connected in series with the first current sensor;
a communication unit (51) configured to receive a first current value measured by the first current sensor and a second current value measured by the second current sensor; **characterised in that** the current sensor diagnosing system further comprises
a control unit (53) configured to select a current section to which the first current value and the second current value belong among a plurality of current sections distinguished by a size of a current, calculate a difference value between the first current value and the second current value, compare the difference value with a section reference value corresponding to the selected current section, and diagnose a state of the first current sensor and the second current sensor.

2. The current sensor diagnosing system of claim 1, wherein:
the section reference value is determined by multiplying a predetermined current value among a plurality of current values belonging to the current section by a predetermined error ratio.

3. The current sensor diagnosing system of claim 2, wherein:
the section reference value is determined by multiplying a maximum current value of the current section by a predetermined error ratio.

4. The current sensor diagnosing system of claim 1, further comprising:
a storage unit (55) for storing a minimum current value, a maximum current value, and a section reference value of each of the plurality of current sections.

5. The current sensor diagnosing system of claim 1, wherein:
when the difference value is equal to greater than the section reference value,
the control unit diagnoses at least one of the first current sensor and the second current sensor as an error state.

6. A battery system, comprising:
a battery (10) including a plurality of battery cells;
a current sensor diagnosing system according to claim 1, whereby the first current sensor (31) is connected in series to a current path between the battery and an external device to measure a charging current or a discharging current of the battery; and
a Battery Management System (BMS) (50) comprising the communication unit and the control unit.

7. The battery system of claim 6, wherein:
the section reference value is determined by multiplying a predetermined current value among a plurality of current values belonging to the current section by a predetermined error ratio.

8. The battery system of claim 7, wherein:
the section reference value is determined by multiplying a maximum current value of the current section by a predetermined error ratio.

9. The battery system of claim 6, wherein:
when the difference value is equal to greater than the section reference value,
the BMS diagnoses at least one of the first current sensor and the second current sensor (33) as an error state.

10. A current sensor diagnosing method, comprising:
receiving (S100) a first current value measured by a first current sensor and a second current value measured by a second current sensor connected in series with the first current sensor;
**characterised in that** the method further comprises
selecting a current section to which the first current value and the second current value belong among a plurality of current sections distinguished by a size of a current, and determining (S200) a section reference value corresponding to the selected current section;
comparing (S310) a difference value between the first current value and the second current value with the section reference value; and
diagnosing (S330, S350) a state of the first current sensor and the second current sensor based on a result of the comparison.

11. The current sensor diagnosing method of claim 10, wherein:
the determining of the section reference value includes
determining the section reference value by multiplying a predetermined current value among a plurality of current values belonging to the current section by a predetermined error ratio.

12. The current sensor diagnosing method of claim 11, wherein:
the determining of the section reference value includes
determining the section reference value by multiplying a maximum current value of the current section by a predetermined error ratio.

13. The current sensor diagnosing method of claim 10, wherein:
the diagnosing of the state includes:
when the difference value is equal to greater than the section reference value,
diagnosing at least one of the first current sensor and the second current sensor as an error state.

## Patentansprüche

1. Stromsensor-Diagnosesystem, umfassend:
einen ersten Stromsensor (1);
einen zweiten Stromsensor (3), welcher mit dem ersten Stromsensor in Reihe geschaltet ist;
eine Kommunikationseinheit (51), welche dazu eingerichtet ist, einen ersten Stromwert, welcher durch den ersten Stromsensor gemessen wird, und einen zweiten Stromwert zu empfangen, welcher durch den zweiten Stromsensor gemessen wird;
**dadurch gekennzeichnet, dass** das Stromsensor-Diagnosesystem ferner umfasst:
eine Steuereinheit (53), welche dazu eingerichtet ist, einen Strombereich, zu welchem der erste Stromwert und der zweite Stromwert gehören, unter einer Mehrzahl von Strombereichen auszuwählen, welche sich durch eine Größe eines Stroms unterscheiden, einen Differenzwert zwischen dem ersten Stromwert und dem zweiten Stromwert zu berechnen, den Differenzwert mit einem Bereichsreferenzwert zu vergleichen, welcher dem ausgewählten Strombereich entspricht, und einen Zustand des ersten Stromsensors und des zweiten Stromsensors zu diagnostizieren.

2. Stromsensor-Diagnosesystem nach Anspruch 1, wobei:
der Bereichsreferenzwert durch Multiplizieren eines vorbestimmten Stromwertes unter einer Mehrzahl von Stromwerten, welche zu dem Strombereich gehören, mit einem vorbestimmten Fehlerverhältnis bestimmt wird.

3. Stromsensor-Diagnosesystem nach Anspruch 2, wobei:
der Bereichsreferenzwert durch Multiplizieren eines maximalen Stromwertes des Strombereichs mit einem vorbestimmten Fehlerverhältnis bestimmt wird.

4. Stromsensor-Diagnosesystem nach Anspruch 1, ferner umfassend:
eine Speichereinheit (55) zum Speichern eines minimalen Stromwertes, eines maximalen Stromwertes und eines Bereichsreferenzwertes von jedem aus der Mehrzahl von Strombereichen.

5. Stromsensor-Diagnosesystem nach Anspruch 1, wobei:
wenn der Differenzwert gleich bis größer als der Bereichsreferenzwert ist,
die Steuereinheit wenigstens einen aus dem ersten Stromsensor und dem zweiten Stromsensor als einen Fehlerzustand diagnostiziert.

6. Batteriesystem, umfassend:
eine Batterie (10), welche eine Mehrzahl von Batteriezellen umfasst;
ein Stromsensor-Diagnosesystem nach Anspruch 1, wobei der erste Stromsensor (31) mit einem Strompfad zwischen der Batterie und einer externen Vorrichtung in Reihe geschaltet ist, um einen Ladestrom oder einen Entladestrom der Batterie zu messen; und
ein Batterieverwaltungssystem (BMS) (50), welches die Kommunikationseinheit und die Steuereinheit umfasst.

7. Batteriesystem nach Anspruch 6, wobei:
der Bereichsreferenzwert durch Multiplizieren eines vorbestimmten Stromwertes unter einer Mehrzahl von Stromwerten, welche zu dem Strombereich gehören, mit einem vorbestimmten Fehlerverhältnis bestimmt wird.

8. Batteriesystem nach Anspruch 7, wobei:
der Bereichsreferenzwert durch Multiplizieren eines maximalen Stromwertes des Strombereichs mit einem vorbestimmten Fehlerverhältnis bestimmt wird.

9. Batteriesystem nach Anspruch 6, wobei:
wenn der Differenzwert gleich bis größer als der Bereichsreferenzwert ist,
das BMS wenigstens einen aus dem ersten Stromsensor und dem zweiten Stromsensor (33) als einen Fehlerzustand diagnostiziert.

10. Stromsensor-Diagnoseverfahren, umfassend:
Empfangen (S100) eines ersten Stromwertes, welcher durch einen ersten Stromsensor gemessen wird, und eines zweiten Stromwertes, welcher durch einen zweiten Stromsensor gemessen wird, welcher mit dem ersten Stromsensor in Reihe geschaltet ist;
**dadurch gekennzeichnet, dass** das Verfahren ferner umfasst:
Auswählen eines Stromabschnitts, zu welchem der erste Stromwert und der zweite Stromwert gehören, unter einer Mehrzahl von Strombereichen, welche sich durch eine Größe eines Stroms unterscheiden, und Bestimmen (S200) eines Bereichsreferenzwertes, welcher dem ausgewählten Strombereich entspricht;
Vergleichen (S310) eines Differenzwertes zwischen dem ersten Stromwert und dem zweiten Stromwert mit dem Bereichsreferenzwert; und
Diagnostizieren (S330, S350) eines Zustands des ersten Stromsensors und des zweiten Stromsensors auf Grundlage eines Ergebnisses des Vergleichs.

11. Stromsensor-Diagnoseverfahren nach Anspruch 10, wobei:
das Bestimmen des Bereichsreferenzwertes umfasst:
Bestimmen des Bereichsreferenzwertes durch Multiplizieren eines vorbestimmten Stromwertes unter einer Mehrzahl von Stromwerten, welche zu dem Strombereich gehören, mit einem vorbestimmten Fehlerverhältnis.

12. Stromsensor-Diagnoseverfahren nach Anspruch 11, wobei:
das Bestimmen des Bereichsreferenzwertes umfasst:
Bestimmen des Bereichsreferenzwertes durch Multiplizieren eines maximalen Stromwertes des Strombereichs mit einem vorbestimmten Fehlerverhältnis.

13. Stromsensor-Diagnoseverfahren nach Anspruch 10, wobei:
das Diagnostizieren des Zustands umfasst:
wenn der Differenzwert gleich bis größer als der Bereichsreferenzwert ist,
Diagnostizieren wenigstens eines aus dem ersten Stromsensor und dem zweiten Stromsensor als einen Fehlerzustand.

## Revendications

1. Système de diagnostic de capteur de courant, comprenant :
un premier capteur de courant (1) ;
un deuxième capteur de courant (3) connecté en série au premier capteur de courant ;
une unité de communication (51) configurée pour recevoir une première valeur de courant mesurée par le premier capteur de courant et une deuxième valeur de courant mesurée par le deuxième capteur de courant ; **caractérisé en ce que** le système de diagnostic de capteur de courant comprend en outre
une unité de commande (53) configurée pour sélectionner une section de courant à laquelle appartiennent la première valeur de courant et la deuxième valeur de courant parmi une pluralité de sections de courant distinguées par une taille d'un courant, calculer une valeur de différence entre la première valeur de courant et la deuxième valeur de courant, comparer la valeur de différence à une valeur de référence de section correspondant à la section de courant sélectionnée, et diagnostiquer un état du premier capteur de courant et du deuxième capteur de courant.

2. Système de diagnostic de capteur de courant selon la revendication 1, dans lequel : la valeur de référence de section est déterminée en multipliant une valeur de courant prédéterminée parmi une pluralité de valeurs de courant appartenant à la section de courant par un taux d'erreur prédéterminé.

3. Système de diagnostic de capteur de courant selon la revendication 2, dans lequel : la valeur de référence de section est déterminée en multipliant une valeur de courant maximale de la section de courant par un taux d'erreur prédéterminé.

4. Système de diagnostic de capteur de courant selon la revendication 1, comprenant en outre :
une unité de stockage (55) pour stocker une valeur de courant minimale, une valeur de courant maximale et une valeur de référence de section de chacune de la pluralité de sections de courant.

5. Système de diagnostic de capteur de courant selon la revendication 1, dans lequel :
lorsque la valeur de différence est supérieure ou égale à la valeur de référence de section,
l'unité de commande diagnostique au moins un parmi le premier capteur de courant et le deuxième capteur de courant en tant qu'état d'erreur.

6. Système de batterie, comportant :
une batterie (10) comportant une pluralité de cellules de batterie ;
un système de diagnostic de capteur de courant selon la revendication 1, dans lequel le premier capteur de courant (31) est connecté en série à un chemin de courant entre la batterie et un dispositif externe pour mesurer un courant de charge ou un courant de décharge de la batterie ; et
un système de gestion de batterie (BMS) (50) comprenant l'unité de communication et l'unité de commande.

7. Système de batterie selon la revendication 6, dans lequel :
la valeur de référence de section est déterminée en multipliant une valeur de courant prédéterminée parmi une pluralité de valeurs de courant appartenant à la section de courant par un taux d'erreur prédéterminé.

8. Système de batterie selon la revendication 7, dans lequel :
la valeur de référence de section est déterminée en multipliant une valeur de courant maximale de la section de courant par un taux d'erreur prédéterminé.

9. Système de batterie selon la revendication 6, dans lequel :
lorsque la valeur de différence est supérieure ou égale à la valeur de référence de section,
le BMS diagnostique au moins un parmi le premier capteur de courant et le deuxième capteur de courant (33) en tant qu'état d'erreur.

10. Procédé de diagnostic de capteur de courant, comprenant :
la réception (S100) d'une première valeur de courant mesurée par un premier capteur de courant et d'une deuxième valeur de courant mesurée par un deuxième capteur de courant connecté en série au premier capteur de courant ;
**caractérisé en ce que** le procédé comprend en outre :
la sélection d'une section de courant à laquelle appartiennent la première valeur de courant et la deuxième valeur de courant parmi une pluralité de sections de courant distinguées par une taille d'un courant, et la détermination (S200) d'une valeur de référence de section correspondant à la section de courant sélectionnée ;
la comparaison (S310) d'une valeur de différence entre la première valeur de courant et la deuxième valeur de courant à la valeur de référence de section ; et
le diagnostic (S330, S350) d'un état du premier capteur de courant et du deuxième capteur de courant sur la base d'un résultat de la comparaison.

11. Procédé de diagnostic de capteur de courant selon la revendication 10, dans lequel :
la détermination de la valeur de référence de section inclut
la détermination de la valeur de référence de section en multipliant une valeur de courant prédéterminée parmi une pluralité de valeurs de courant appartenant à la section de courant par un taux d'erreur prédéterminé.

12. Procédé de diagnostic de capteur de courant selon la revendication 11, dans lequel :
la détermination de la valeur de référence de section inclut
la détermination de la valeur de référence de section en multipliant une valeur de courant maximale de la section de courant par un taux d'erreur prédéterminé.

13. Procédé de diagnostic de capteur de courant selon la revendication 10, dans lequel :
le diagnostic de l'état inclut :
lorsque la valeur de différence est supérieure ou égale à la valeur de référence de section,
le diagnostic d'au moins un parmi le premier capteur de courant et le deuxième capteur de courant en tant qu'état d'erreur.
